# EUROPEAN PATENT APPLICATION

(11) **EP 1 768 185 A1**
(43) Date of publication of application: **28.03.2007**
(21) Application number: 05741161.3
(22) Date of filing: 19.05.2005
(51) Int. Cl.: H01L 27/12, H01L 21/322

(54) **PROCESS FOR PRODUCING SIMOX SUBSTRATE AND SIMOX SUBSTRATE PRODUCED BY THE PROCESS**

(30) Priority: 25.05.2004 JP 2004154624
(71) Applicant: SUMCO Corporation, Tokyo 105-8634 (JP)
(72) Inventor: ADACHI, Naoshi, Minato-ku, Tokyo105-8634 (JP)
(74) Representative: Albrecht, Thomas
(86) International application number: PCT/JP2005/009166
(87) International publication number: WO 2005/117122

(57) **Abstract**

It is possible to efficiently capture heavy metal contamination due to ion implantation or high-temperature heat treatment in a bulk layer.

It is **characterized** that the present method comprises: a step of implanting oxygen ions into a wafer 11; a step of applying first heat treatment to a wafer under a predetermined gas atmosphere at 1,300 to 1,390°C and forming a buried oxide layer 12 and an SOI layer 13 by applying first heat treatment to a wafer at 1,300 to 1390°C; a second heat treatment step in which a wafer before oxygen ions are implanted has an oxygen concentration of 9×10¹⁷ to 1.8×10¹⁸ atoms/cm³ (old ASTM) and a buried oxide layer is formed entirely or locally in the wafer to form oxygen precipitate nuclei 14b formed in the wafer before the oxygen ion implantation step or between the oxygen ion implantation step and the first heat treatment step; and a third heat treatment step of growing oxygen precipitate nuclei 14b formed in the wafer so as to be oxygen precipitates 14c.

## Description

### TECHNICAL FIELD

The present invention relates to a method for manufacturing a SIMOX substrate and a SIMOX substrate obtained by the method among SOI (Silicon-On-Insulator) substrates in each of which a single-crystal silicon layer (hereafter referred to as SOI layer) is formed on a single crystal silicon body through a buried oxide layer according to the SIMOX (Separation by Implanted Oxygen) technique. More particularly, the present invention relates to a SIMOX substrate manufacturing method capable of efficiently capturing heavy metal contamination due to ion implantation or high-temperature heat treatment into the SIMOX substrate and a SIMOX substrate obtained by the method.

### BACKGROUND ART

An SOI substrate (1) makes it possible to speed up a device operation because a parasitic capacitance between an element and a substrate can be decreased, (2) which is superior in radiation withstand voltage, and (3) which realizes high integration because dielectric separation is easy and (4) moreover, which as a very superior feature such as capability of improving the latch-up-resistance characteristic. The SOI substrate manufacturing method can be roughly divided into two methods at present. One of the methods is a method for mutually bonding an active wafer to be formed into a film thickness and a support wafer and other of them is a SIMOX method for forming a buried oxide layer in a region at a predetermined depth from the surface of a wafer by implanting oxygen ions from the wafer surface. Particularly, the SIMOX method is expected as an effective technique because it has a small number of manufacturing steps.
A SIMOX substrate manufacturing method comprises an oxygen implantation step of mirror-polishing a main surface of a single-crystal substrate and then implanting oxygen ions at a predetermined depth of the substrate through ion implantation and a high-temperature heat treatment step of forming a buried layer in the substrate by applying high-temperature heat treatment to the substrate into which oxygen ions are implanted under oxidation atmosphere. Specifically, the single-crystal silicon substrate is held at a temperature of 500 to 650°C to implant 10¹⁷ to 10¹⁸ pieces/cm² oxygen atom ions or oxygen molecule ions to a predetermined thickness from the surface of the substrate. Then, the silicon substrate into which oxygen ions are implanted is put in a heat treatment furnace held at a temperature of 500 to 700°C and a temperature rise is gradually started so as not to cause slip, and heat treatment is applied to the substrate at a temperature of 1,300 to 1,390°C for about 10 hours. Oxygen ions implanted into the substrate by this high-temperature treatment react with silicon and a buried layer is formed in the substrate.

In a process for manufacturing a device, as gettering techniques for removing a metal directly affecting a device characteristic from the surface of a substrate, there are a method for forming distortion on the back of a substrate through sand blast, a method for depositing a polycrystal silicon film on the back of a substrate, and an external gettering method (External Gettering) for implanting high-concentration phosphor to the back of a substrate. However, an internal gettering method (Intrinsic Gettering) using the distortion field of a crystal defect due to oxygen precipitates formed in a silicon substrate is superior in mass production and is locally used for mass production as a clean gettering method.
However, because a buried oxide layer is formed in a SIMOX substrate, high-temperature heat treatment at about 1300°C is required after implanting oxygen ions. Therefore, it has been said that it is difficult to form oxygen precipitates serving as internal gettering sink in a bulk layer through the high-temperature heat treatment. Specifically, there are point defects in a single-crystal silicon wafer, that is, an interstitial point defect formed when Si atoms enter between lattices and a vacancy point defect privative in Si atoms forming a lattice and these point defects are present in thermal balance. For example, it is disclosed that 1 × 10¹⁷ pieces/cm³ interstitial point defects and 1×10¹⁵ pieces/cm³ vacancy point defects are present at 1200°C and 1 × 10¹⁶ pieces/cm³ interstitial point defects and 1 × 10⁵ pieces/cm³ vacancy point defects are present at 600°C (for example, refer to Patent Document 1). That is, point defects are present in thermal balance and it is known that the point defect density at 1200°C becomes higher than that at 600°C. Therefore, when applying high-temperature heat treatment at about 1300°C before the high-temperature heat treatment for forming a buried oxide layer and SOI layer and then forming oxygen precipitates in a bulk layer at a predetermined temperature lower than the temperature of the high-temperature heat treatment, it has been considered that oxygen precipitates formed in the bulk layer disappears due to the high-temperature heat treatment.

To solve the above problem, there is proposed a semiconductor-substrate manufacturing method in which oxygen ions are implanted into a single-crystal silicon substrate and then the heat treatment is applied to the substrate at 1,200 to 1,300°C for 6 to 12 hours in a hydrogen atmosphere or nitrogen atmosphere containing a small amount of oxygen to form a buried oxide layer and then temperature is stepwise or continuously raised from a low temperature to a high temperature to apply heat treatment (for example, refer to Patent Document 2). As the specific heat-treatment condition shown in the Patent Document 2, there are described methods ,wherein a stepwise heat treatment method starts to be performed from 500°C and a temperature is raised by 50 to 100°C sequentially to the final temperature of 850°C ,and wherein a consecutive heat treatment method starts to be performed from 500°C at a gradient of 0.2 to 1.0°C/minute. However, contraction and disappearance of oxygen nuclei precipitated at the time of pulling out crystal occur by applying high-temperature heat treatment at about 1,300°C in order to form a buried oxide layer of a SIMOX substrate. Therefore, the growth of oxygen precipitates is suppressed under the heat treatment condition shown in Patent Document 2. Therefore, a sufficient gettering effect is not obtained at the final temperature of 850°C.

Moreover, there are proposed a SIMOX substrate with a structure having a region in which a buried oxide layer is not locally formed and having a gettering means due to crystal defect or crystal distortion in a silicon-substrate bulk or on the rear surface of a single-crystal silicon substrate and its manufacturing method (for example, refer to Patent Document 3). In this Patent Document 3, it is described that a buried oxide layer is fragmentarily formed nearby a surface layer, oxygen precipitate nuclei are formed under a heat treatment condition for gettering which ranges between 500 and 900°C, the density ranges between 10⁵ pieces/cm³ and 10⁹ pieces/cm³, and it is allowed to grow the above precipitate nuclei serving as precipitates in the range of 1,000 to 1,150°C as second heat treatment.

However, though the number of crystal defects on the substrate surface due to fixed amount of contamination of a heavy metal is evaluated by as a reference sample using SIMOX according to prior art, that is, SIMOX in which a buried oxide layer is grown on the entire surface of a wafer in an example, though most of surface defects are not observed in the case of the example of a local buried oxide film, 10⁵ to 10⁶ pieces/cm² pits and laminated defects are observed in the conventional SIMOX. That is, it is represented that a complete gettering technique is not established even in Patent Document 2.
Patent Document 1: Japanese Patent Publication No. H3-9078 (sixth line to 13th line in third column on page 2)
Patent Document 2: Japanese Unexamined Patent Application No. H7-193072 (Claims 1 to 3)
Patent Document 3: Japanese Unexamined Patent Application No. H5-82525 (Claims 1, 2, 4 and 5, paragraphs [0019] to [0023])
Non-patent Document 1 J.Eelctronchem. Soc., 142,2059, (1995)

### DISCLOSURE OF THE INVENTION

### PROBLEMS TO BE SOLVED BY THE INVENTION

It is disclosed that a defect collection layer having a thickness of about 200nm is inevitably formed immediately below a buried oxide layer as a feature for manufacturing a SIMOX substrate and the defect collection layer has a gettering effect (for example, refer to the above Non-Patent Document 1). That is, according to the content of disclosure in Non-Patent Document 1, when heavy metal contamination unexpectedly occurs and a sufficient gettering effect cannot be obtained from oxygen precipitates of the SMOX substrate shown in the above Patent Document 2 and Patent Document 3, it is considered that a heavy metal is captured in the defect collection layer immediately below the buried oxide layer.

Moreover, because a thin film of the SOI layer in a SIMOX substrate has been requested in recent years, a heavy-metal contamination region captured in a defect collection layer immediately below a buried oxide layer may influence a device characteristic. It has been necessary to design a SIMOX substrate having a gettering source capable of efficiently capturing unexpected heavy-metal contamination in a process at least without influencing a device characteristic.

It is an object of the present invention to provide a SIMOX substrate manufacturing method capable of efficiently capturing heavy metal contamination due to ion implantation or high-temperature heat treatment in a bulk layer by forming a gettering sink in a bulk layer before the high-temperature heat treatment for forming a buried oxide layer and an SOI layer, and a SIMOX substrate obtained from the method.
It is another object of the present invention to provide a SIMOX substrate manufacturing method capable of decreasing the heavy-metal capturing concentration of a defect collection layer and efficiently capturing a heavy metal in a bulk layer and a SIMOX substrate obtained from the method.

### MEANS FOR SOLVING PROBLEM

As a result of earnestly studying an event which has been conventionally considered as the fact that formed oxygen precipitates disappear by applying high-temperature heat treatment for forming a buried layer and an SOI layer on the buried layer in the substrate after applying heat treatment for forming oxygen precipitates, when the size of formed oxygen precipitate is large, the present inventor et al. know that oxygen precipitates remain even if applying high-temperature heat treatment in a subsequent step and realize the present invention.

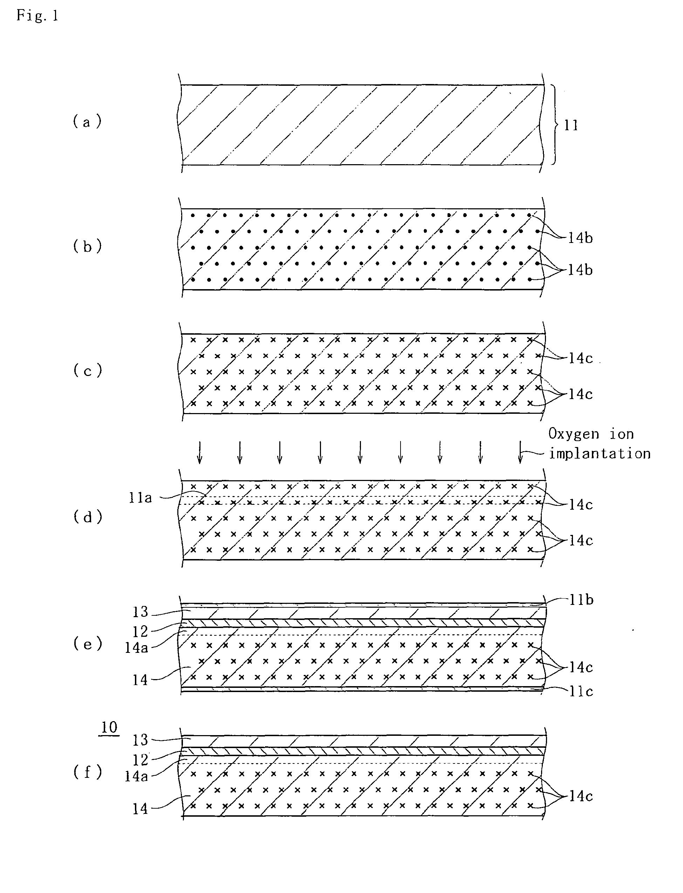

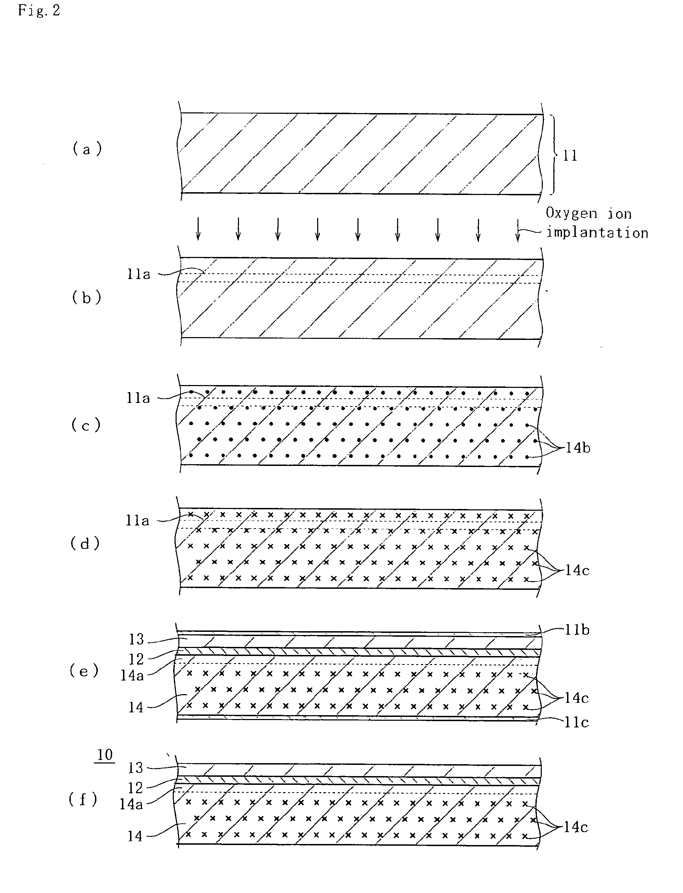

As shown in Figs. 1(a) to 1(f) or Figs 2(a) to 2(f), the invention of claim 1 is an improved SIMOX substrate manufacturing method including an oxygen ion implantation step of implanting oxygen ions into a silicon wafer 11 and a first heat treatment step of forming a buried oxide layer 12 in a region at a predetermined depth from the surface of the wafer 11 by applying first heat treatment to the wafer 11 in a mixed gas atmosphere of oxygen and inert gas at 1,300 to 1390°C and forming an SOI layer 13 on the buried oxide layer 12.
The characteristic configuration lies in that the silicon wafer 11 before oxygen ion implantation has an oxygen concentration of 9×10¹⁷ to 1.8×10¹⁸ atoms/cm³ (old ASTM), and the buried oxide layer 12 is entirely or locally formed in the wafer, and the present method further comprises a second heat treatment step of forming oxygen precipitate nuclei 14b in the wafer 11 before an oxygen ion implantation step or between the oxygen ion implantation step and the first heat treatment step, and a third heat treatment step of growing oxygen precipitate nuclei 14b formed in the wafer 11 continued from the second heat treatment step so as to be oxygen precipitates 14c.
By applying the second heat treatment step and third heat treatment step, which grow oxygen precipitates 14c, before the oxygen ion implantation step or between the oxygen ion implantation step and the first heat treatment step, the invention of claim 1 makes it possible to efficiently capture heavy metal contamination due to ion implantation or high-temperature heat treatment into a bulk layer 14 by the oxygen precipitates 14c formed through the second and third heat treatments. Through each of the above steps, it is possible to obtain a SIMOX substrate which has a gettering source constituted of the oxygen precipitates 14c in a bulk layer 14 below the defect collection layer 14a and in which the density of the oxygen precipitate 14c ranges betweenl×10⁸ to 1×10¹² pieces /cm³ and the size of the oxygen precipitate 14c is 50 nm or bigger.

The invention of claim 2 according to claim 1, in which second heat treatment in the second heat treatment step is performed by holding a wafer at a temperature of 500 to 900°C for 1 to 96 hours in the atmosphere of any one of hydrogen, argon, nitrogen, and oxygen gas or a mixed gas atmosphere thereof and third heat treatment in the third heat treatment step is a manufacturing method performed by holding a second-heat-treated wafer under an atmosphere of any one of hydrogen, argon, nitrogen, and oxygen gases or a mixed gas atmosphere thereof at the temperature of 900 to 1250°C , which is higher than the second heat treatment temperature for 1 to 96 hours.

The invention of claim 3 according to claim 1 is a method further including fourth heat treatment step of regrowing oxygen precipitates 14c formed in a bulk layer 14 below a buried oxide layer 12 by performing fourth heat treatment for holding a first-heat-treated wafer at 500 to 1200°C for 1 to 96 hours.
The invention of claim 3 makes it possible to regrow the size of the oxygen precipitate 14c by applying fourth heat treatment.

The invention of claim 4 according to claim 1 or 2 is a method in which second heat treatment in a second heat treatment step is performed in the range of 1 to 96 hours by raising temperature at the rate of 0.1 to 20.0°C/minute in a partial range or the whole range between 500 and 900°C and third heat treatment in third heat treatment step is a manufacturing method performed in the range of 1 to 96 hours by raising temperature at a rate of 1 to 20°C/minute in a partial range or the whole range between 900 and 1250°C.

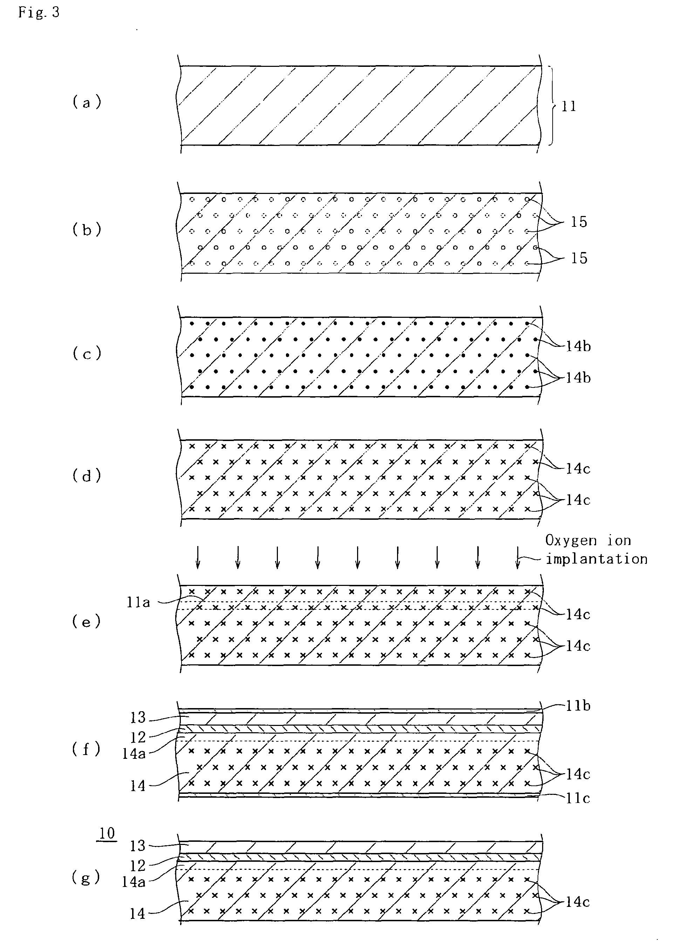

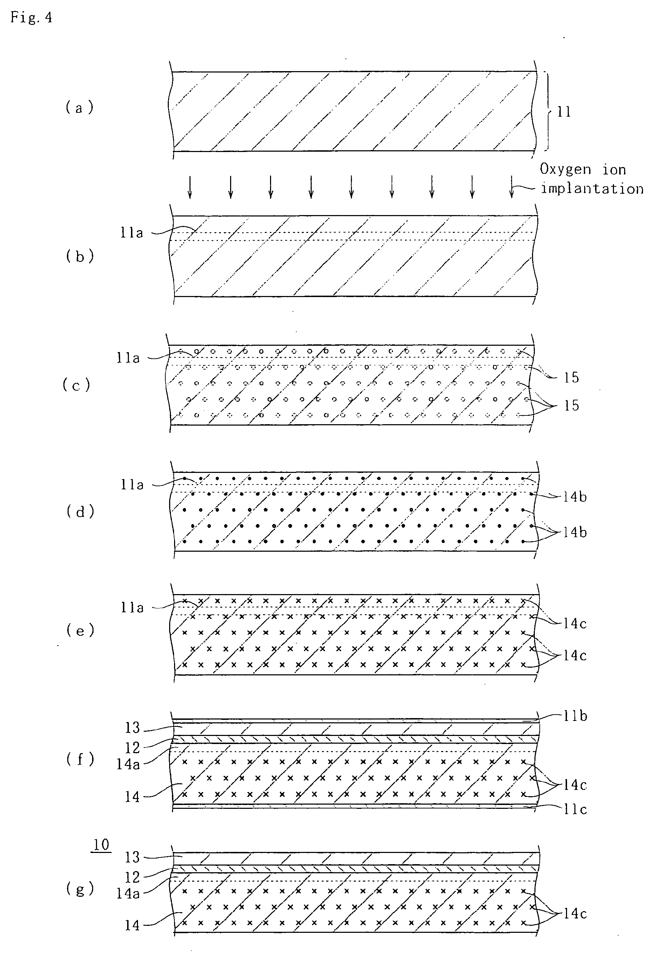

As shown in Figs. 3(a) to 3(g) or Figs. 4(a) to 4(g), the invention of claim 5 is an improved SIMOX substrate manufacturing method including an oxygen ion implantation step of implanting oxygen ions into a silicon wafer 11 and a first heat treatment step of forming a buried oxide layer 12 in a region at a predetermined depth from the surface of a wafer 11 by applying first heat treatment to the wafer 11 in a mixed gas atmosphere of oxygen and inert gas at 1,300 to 1390°C and forming an SOI layer 13 on the buried oxide layer 12.
The characteristic configuration lies in that the silicon wafer 11 before oxygen ion implantation has an oxygen concentration of 9 × 10¹⁷ to 1.8 × 10¹⁸ atoms/cm³ (old ASTM), and the buried oxide layer 12 is formed entirely or partially in the wafer, and the present method comprises a rapid heat treatment step of forming a vacancy 15 in the wafer 11 before an oxygen ion implantation step or between the oxygen ion implantation step and the first heat treatment step, and a third heat treatment step of growing oxygen precipitate nuclei 14b formed in the wafer 11 continued from the second heat treatment step to oxygen precipitates 14c.
In the invention of claim 5, by applying a rapid heat treatment step of forming the vacancy 15 in a wafer 11 and second and third heat treatments for growing oxygen precipitates 14c before the oxygen ion implantation step or between the oxygen ion implantation step and the first heat treatment step and by applying second and third heat treatments for growing oxygen precipitates 14c, it is possible to efficiently capture heavy metal contamination due to ion implantation or high-temperature heat treatment into a bulk layer 14 by the oxygen precipitates 14c formed through second and third heat treatments. Moreover, by applying the rapid heat treatment step, the in-plane uniformity of oxygen precipitate density distribution in the plane of the wafer 11 is secured and the certainty of oxygen precipitate growth is improved even in the case of a silicon wafer having a low oxygen concentration. Through each of the above steps, it is possible to obtain a SIMOX substrate which has a gettering source constituted of oxygen precipitates 14c in a bulk layer 14 below the defect collection layer 14a and in which the density of the oxygen precipitate 14c ranges between 1 × 10⁸ to 1 × 10¹² pieces/cm³ and the size of the oxygen precipitate 14c is 50 nm or bigger.

The invention of claim 6 according to claim 5 is a method in which rapid heat treatment in a rapid heat treatment step is performed by holding a wafer under a mixed gas atmosphere with a non-oxidation gas or ammonia gas at 1,050 to 1,350°C for 1 to 900 seconds and then lowering temperature at a lowering rate of 10°C/second or more, second heat treatment in a second heat treatment step is performed by holding a rapidly-heat-treated wafer under an atmosphere of any one of hydrogen, argon, nitrogen and oxygen gases or a mixed gas atmosphere thereof at 500 to 1000°C for 1 to 96 hours, and third heat treatment in a third heat treatment step is performed by holding a second-heat-treated wafer under an atmosphere of any one of hydrogen, argon, nitrogen, and oxygen gas or a mixed gas atmosphere thereof at 900 to 1250°C, which is higher than the second heat treatment temperature for 1 to 96 hr.

The invention of claim 7 according to claim 5 is a method further including a step of regrowing oxygen precipitates 14c formed in a bulk layer 14 lower than a buried oxide layer 12 by applying fourth heat treatment to a first-heat-treated wafer at 500 to 1200°C for 1 to 96 hours.
The invention of claim 7 makes it possible to regrow the size of oxygen precipitate 14c by applying fourth heat treatment.

The invention of claim 8 according to claim 5 or 6 is a manufacturing method in which second heat treatment in second heat treatment step is performed in the range of 1 to 96 hours by raising temperature at the rate of 20.0°C /minute in a partial range or whole range between 500 and 1,000°C and third heat treatment in a third heat treatment step is performed in the range of 1 to 96 hours by raising temperature at a rate of 0.1 to 20°C/minute in a partial range or the whole range between 1,000 and 1,250°C in the range of 1 to 96 hours.

The invention of claim 9 is a SIMOX substrate manufactured in accordance with the method of any one of claims 1 to 8, which is provided with a buried oxide layer 12 formed in a region at a predetermined depth from the surface of a wafer, SOI layer 13 formed on the buried oxide layer, defect collection layer 14a formed immediately below the buried oxide layer 12, and bulk layer 14 below the buried oxide layer 12, wherein a gettering source constituted of oxygen precipitates 14c is included in a bulk layer 14 below the defect collection layer 14a is included, the density of the oxygen precipitates 14c ranges between 1×10⁸ to 1 × 10¹² pieces/cm³, and the size of the oxygen precipitate 14c is 50 nm or bigger.
In the invention of claim 9, a gettering source constituted of oxygen precipitates 14c is included in a bulk layer 14 below a defect collection layer 14a and the density of oxygen precipitate 14c ranges between 1×10⁸ to 1 × 10¹² pieces/cm³. The size of the oxygen precipitate 14c, which is 50 nm or bigger, makes the gettering source stronger than the defect collection layer. Therefore, it is possible to capture most of heavy metal contamination, conventionally captured in a defect collection layer 14a, in oxygen precipitates 14c of a bulk layer 14 without being captured by the defect collection layer.

### EFFECT OF THE INVENTION

A SIMOX substrate manufacturing method of the present invention makes it possible to efficiently capture heavy metal contamination due to subsequent ion implantation or high-temperature heat treatment into a bulk layer by oxygen precipitates formed through the second and third heat treatments by including a second heat treatment step and third heat treatment step before an oxygen ion implantation step or between the oxygen ion implantation step and the first heat treatment step or including a rapid heat treatment step, second heat treatment step, and third heat treatment step. Moreover, The SIMOX substrate of the present invention has a gettering source constituted of oxygen precipitates in a bulk layer below a defect collection layer, the density of the oxygen precipitate ranges between 1 × 10⁸ to 1 × 10¹² pieces/cm³, and the size of the oxygen precipitate is 50 nm or bigger. This makes a gettering source stronger than a defect collection layer. Therefore, it is possible to decrease the heavy-metal capturing concentration of the defect collection layer and effectively capture heavy metal in a bulk layer.

### BRIEF DESCRIPTION OF DRAWINGS

Fig. 1 is a view showing a method for manufacturing a SIMOX substrate in the first example of the present invention;
Fig. 2 is a view showing another method for manufacturing a SIMOX substrate in the first example;
Fig. 3 is a view showing a method for manufacturing a SIMOX substrate in the second example of the present invention; and
Fig. 4 is a diagram showing another method for manufacturing a SIMOX substrate in the second example of the present invention.

### EXPLANATIONS OF LETTERS OR NUMERALS

- 10:: SIMOX substrate
- 11:: Silicon wafer
- 12:: Buried oxide layer
- 13:: SOI layer
- 14:: Bulk layer
- 14a:: Defect collection layer
- 14b:: Oxygen precipitate nuclei
- 14c:: Oxygen precipitates
- 15:: Vacancy

### BEST MODE FOR CARRYING OUT THE INVENTION

The first best mode for carrying out the present invention is described below by referring to the accompanying drawings.
The present invention relates to a SIMOX substrate in which a buried oxide layer is formed in a region at a predetermined depth from the surface of a silicon wafer by implanting oxygen ions into the wafer and then performing first heat treatment in a mixed gas atmosphere of oxygen and inert gas at 1,300 to 1390°C and an SOI layer is formed on the surface of the buried oxide layer. Then, as shown in Figs. 1 (a) to 1(f), a characteristic configuration of a method for manufacturing a SIMOX substrate in the present invention comprises a second heat treatment step of forming an oxygen precipitate nuclei 14b in a wafer 11 before an oxygen ion implantation step or between the oxygen ion implantation step and a first heat treatment step and a third heat treatment step of growing oxygen precipitate nuclei 14b formed in the wafer 11 continued from the second heat treatment step so as to be oxygen precipitates 14c. In this example, a method for applying the second heat treatment step and the third heat treatment step continued from the second heat treatment step are described in detail in order, respectively.

### (1-1) Second heat treatment step

First, as shown in Fig. 1(a), a silicon wafer 11 is prepared. The prepared silicon wafer 11 has an oxygen concentration of 9×10¹⁷ to 1.8×10¹⁸ atoms/cm³ (old ASTM). It is allowed to use the prepared silicon wafer as an epitaxial wafer or annealed wafer.
Then, as shown in Fig. 1(b), second heat treatment is applied to the prepared silicon wafer 11. By applying the second heat treatment to the wafer 11, oxygen precipitate nuclei 14b are formed in the wafer 11. It is preferable that the second heat treatment in the second heat treatment step is performed by holding the wafer under an atmosphere of any one of hydrogen, argon, nitrogen, and oxygen gases or a mixed gas atmosphere thereof at the temperature of 500 to 900°C for 1 to 96 hours. It is further preferable that the gas atmosphere of the second heat treatment is realized under argon or trace quantity oxygen (nitrogen or argon gas base) gas atmosphere. The second heat treatment temperature is specified in the range between 500 and 900°C because when the temperature is lower than a lower limit value, the temperature for forming nuclei is so low that a long-time heat treatment is required but when the temperature exceeds an upper limit value, oxygen precipitate nuclei are not produced. Furthermore, the second heat treatment time is specified in the range between 1 and 96 hours because when the time is less than the lower limit value, it is too short to form the oxygen precipitate nuclei but when it exceeds the upper limit value, there occurs a difficulty in productivity. It is preferable that the second heat treatment is performed at a temperature of 500 to 800°C for 4 to 35 hours. Moreover, it is allowed to perform the second heat treatment in the range of 1 to 96 hours, preferably in the range of 4 to 35 hours by raising temperature at a rate of 0.1 to 20.0°C /minute, preferably at a rate of 0.1 to 5.0°C/minute in a partial or the whole range between 500 and 900°C.

### (1-2) Third heat treatment step

As shown in Fig. 1(c), third heat treatment is applied to a second-heat-treated wafer 11. By performing the third heat treatment, it is possible to grow oxygen precipitate nuclei 14b formed in the wafer 11 so as to be oxygen precipitates 14c. It is preferable that the third heat treatment in a third heat treatment step is performed by holding a second-heat-treated wafer under an atmosphere of any one of hydrogen, argon, nitrogen, and oxygen gases or a mixed gas atmosphere thereof at a temperature of 900 to 1250°C higher than the second heat treatment temperature for 1 to 96 hours. It is preferable to realize the gas atmosphere of the third heat treatment under argon or trace-quantity oxygen (nitrogen or argon gas base) gas atmosphere. The third heat treatment temperature is specified in the range of 900 to 1250°C because oxygen precipitates are not sufficiently grown at a temperature lower than a lower limit value but there occurs a trouble due to slip when the temperature exceeds an upper limit value. Moreover, the third heat treatment time is specified in the range of 1 to 96 hours because oxygen precipitates are not sufficiently grown at a temperature lower than a lower limit value but a trouble that the productivity is deteriorated occurs when the temperature exceeds the upper limit value. Furthermore, it is further preferable that the third heat treatment is performed at a temperature of 1,000 to 1200°C for 8 to 24 hours. Furthermore, it is allowed to perform the third heat treatment in the range of 1 to 96 hours, preferably in the range of 8 to 24 hours by raising temperature at a rate of 0.1 to 20°C/minute, preferably at a rate of 1 to 5°C/minute in a partial range or the whole range between 900 and 1,250°C.

### (1-3) Oxygen ion implantation step

Then, as shown in Fig. 1(d), oxygen ions are implanted into a third-heat-treated wafer 11. The implantation of oxygen ions is performed by the same means as those performed so far. Then, oxygen ions are implanted into a region 11a at a predetermined depth from the surface of the wafer 11 so that the thickness of an SOI layer 13 on the SIMOX substrate finally obtained becomes 10 to 200 nm, preferably 20 to 100 nm. When the thickness of the SOI layer 13 is less than 10 nm, it is difficult to control the thickness of the SOI layer 13 but when the thickness of the SOI layer 13 exceeds 200 nm, it is difficult to control the thickness because of the acceleration voltage of an oxygen ion implanter. Moreover, by locally forming a mask or the like at a desired position on the surface of the silicon wafer 11 and then implanting oxygen ions into the silicon wafer 11, oxygen ions are implanted into the wafer below a portion where a mask is not formed, but are not implanted into the wafer below a portion where a mask is formed. Therefore, by applying the subsequent first heat treatment, a buried oxide layer 12 is locally formed only below the portion where the mask is not formed.
Even if heavy metal contamination due to an ion implantation step occurs, it is possible to efficiently capture a heavy metal which is a contaminant into a bulk layer 14 by oxygen precipitates 14c formed by applying the above described second heat treatment step and third heat treatment step.

### (1-4) First heat treatment step

Then, as shown in Fig. 1(e), first heat treatment is applied to the oxygen ion-implanted wafer 11 under a mixed gas atmosphere of oxygen and inert gas at a temperature of 1,300 to 1390°C. As inert gas, argon gas or nitrogen gas is used. Therefore, it is preferable that the gas atmosphere of the first heat treatment is a mixed gas of oxygen and argon or a mixed gas of oxygen and nitrogen. Moreover, it is preferable that the heat treatment time of the first heat treatment ranges between 1 and 20 hours, more preferably ranges between 10 and 20 hours.
Oxide films 11b and 11c are formed on the front surface and the rear surface of the wafer 11 by the first heat treatment and a buried oxide layer 12 is entirely or locally formed in the wafer in a region 11a at a predetermined depth from the surface of the wafer 11. Moreover, an SOI layer 13 is formed between a front side oxide film 11b and a buried oxide layer 12. Furthermore, a defect collection layer 14a is inevitably formed immediately below the buried oxide layer 12. Furthermore, because oxygen precipitates nearby the surface layer is melted through first heat treatment, a DZ layer (Denuded Zone) is formed where oxygen precipitates are not present. Furthermore, oxygen precipitates 14c present on the defect collection layer 14a immediately below the buried oxide layer 12 and the bulk layer 14 located below the layer 14a are further grown through temperature rise in the early stage of the first heat treatment step, the size of the oxygen precipitate is increased, melting of the oxygen precipitate is started by holding the temperature of 1,300 to 1390°C in the middle stage, the size of the oxygen precipitate is decreased up to a certain size. However, the regrowth of the oxygen precipitate is started by temperature lowering at the last stage of the first heat treatment step. Therefore, even if the first heat treatment step is applied, it is estimated that oxygen precipitates 14c previously formed remain in the bulk 14.
Even if heavy metal contamination due to the first heat treatment step occurs, it is possible to efficiently capture a heavy metal which is a contaminant in the bulk layer 14 by oxygen precipitates 14c formed by applying the above-described second heat treatment step and third heat treatment step.

Though not illustrated, it is also allowed that fourth heat treatment is applied which holds a first-heat-treated wafer at 500 to 1200°C for 1 to 96 hours after the first heat treatment. By applying the fourth heat treatment, it is possible to regrow oxygen precipitates 14c formed in the bulk layer 14 below the buried oxide layer 12. It is preferable that the gas atmosphere of the fourth heat treatment is realized under an argon or trace quantity oxygen (nitrogen or argon gas base) gas atmosphere. The fourth heat treatment temperature is specified in the range of 500 to 1200°C because oxygen precipitates 14c are not sufficiently grown at a temperature lower than a lower limit value but when the temperature exceeds an upper limit value, there occurs a trouble due to slip. The fourth heat treatment time is specified in the range of 1 to 96 hours because when the time is shorter than a lower limit value, oxygen precipitates 14c are not sufficiently grown but when the time exceeds an upper limit value, there is a difficulty in productivity. Moreover, it is preferable that the fourth heat treatment is performed at 1,000 to 1200°C for 8 to 24 hours.

### (1-5) Removal step of oxide films 11b and 11c

As shown in the final Fig. 1(f), oxide films 11b and 11c formed on the front surface and the rear surface of a first-heat-treated wafer 11 are removed by hydrofluoric acid. Thereby, there is obtained a SIMOX substrate comprising; a buried oxide layer 12 formed in a region at a predetermined depth from the surface of the wafer, an SOI layer 13 formed on the buried oxide layer, defect collection layer 14a formed immediately below the buried oxide layer 12, and a bulk layer 14 below the buried oxide layer 12, a gettering source constituted of oxygen precipitates 14c included in the bulk layer 14 below the defect collection layer 14a, wherein the density of the oxygen precipitate 14c ranges between 1 × 10⁸ and 1 × 10¹² pieces/cm³, and the size of the oxygen precipitate 14c is 50 nm or bigger.

In the SIMOX substrate, the oxygen precipitate 14c having a density of 1 × 10⁸ to 1 × 10¹² pieces/cm³ and a size of 50 nm or bigger is included in the bulk layer 14 below the defect collection layer 14a. Therefore, it is possible to efficiently capture unexpected heavy-metal contamination by oxygen precipitates 14c in a device process. Moreover, because oxygen precipitates 14c become a gettering source stronger than the defect collection layer 14a, it is possible to get a heavy metal contaminant conventionally captured in the defect collection layer 14a in oxygen precipitates 14c of the bulk layer 14. As a result, for example, when a substrate is forcibly contaminated by a heavy metal so that the substrate is obtained at a heavy metal concentration of 1 × 10¹¹ to 1 × 10¹² pieces/cm², it is possible to decrease the heave metal concentration to be captured of the defect collection layer 14a up to a level of 5 × 10⁹ pieces/cm² or lower. Though it is needless to say, it is possible to also apply the substrate to a SIMOX substrate on which a buried oxide layer is locally formed.

As shown in Fig. 1, in this example, the second heat treatment step and third heat treatment step are applied before the oxygen ion implantation step. However, as shown in Figs. 2(a) to 2(f), respectively, a SIMOX substrate similar to the SIMOX substrate shown in Fig. 1 is obtained even if the second heat treatment step and third heat treatment step are applied between the oxygen ion implantation step and the first heat treatment step.

The second best mode for carrying out the present invention is described below by referring to the accompanying drawings.
The present invention relates to a SIMOX substrate in which a buried oxide layer is formed at a predetermined depth from the surface of a silicon wafer by implanting oxygen ions into the wafer and then first-heat-treating the wafer under a mixed gas atmosphere of oxygen and inert gas at 1,300 to 1,390°C and an SOI layer is formed on the surface of the buried oxide layer. Then, as shown in Fig. 3, the characteristic configuration of a SIMOX substrate manufacturing method of the present invention lies in the fact of including a rapid heat treatment step of forming a vacancy 15 in the wafer 11 before an oxygen implanting step or between the oxygen implanting step and a first heat treatment step, a second heat treatment step of forming oxygen precipitate nuclei 14b in the wafer 11 continued from the rapid heat treatment step, and a third heat treatment step of growing the oxygen precipitate nuclei 14b formed in the wafer 11 continued from the second heat treatment step so as to be oxygen precipitates 14c. In the case of this mode, a method for applying the rapid heat treatment step, second heat treatment step continued from the rapid heat treatment step before the oxygen ion implantation step, and third heat treatment step continued from the second heat treatment step are described in order in detail.

### (2-1) Rapid heat treatment step

As shown in Fig. 3(a), a silicon wafer 11 is prepared. The prepared silicon wafer 11 has an oxygen concentration of 8 × 11¹⁷ to 1.8 × 10¹⁸ atoms/cm³ (old ASTM). It is allowed to use the prepared silicon wafer 11 as an epitaxial wafer or annealed wafer.
Moreover, as shown in Fig. 3(b), the prepared silicon wafer 11 is rapid-heat-treated. By performing the rapid heat treatment, a vacancy 15 is formed in the wafer 11. The rapid heat treatment enables the in-plane uniformity of an oxygen precipitate density distribution in the plane of the wafer to be secured and the certainty of oxygen precipitate growth to be improved even in the case of a silicon wafer having a low oxygen concentration. When the rapid heat treatment is not applied, the oxygen precipitate density distribution in the wafer plane may not be uniformed even if the subsequent step is applied. It is preferable that the rapid heat treatment in a rapid heat treatment step is performed by keeping a wafer under a mixed gas atmosphere of non-oxidation gas or ammonia gas at 1,050 to 1,350°C for 1 to 900 seconds and then, lowering temperature at the temperature lowering rate of 10°C /second or more. The rapid heat treatment temperature is specified in the range of 1,050 to 1,350°C because a sufficient vacancy quantity enough to facilitate formation of oxygen precipitate nuclei cannot be implanted into a wafer at a temperature lower than the lower limit value but when the temperature exceeds an upper limit value, slip transfer occurs in the wafer at the time of heat treatment and a trouble occurs when a device is fabricated. A preferable heat treatment temperature ranges between 1,100 and 1,300°C. Moreover, the holding time is set to 1 to 900 seconds because the time required by a desired heat-treatment temperature differs and this may become a cause of generating the fluctuation of quality in the plane and depth direction of a wafer when the time is less than the lower limit value. The upper limit value is specified, considering slip reduction and productivity. A preferable holding time ranges between 10 and 60 seconds. By holding the above rapid heat treatment for a predetermined time, vacancy is formed in the wafer. However, to keep the vacancy formed in the wafer, the cooling rate for lowering the temperature of the wafer plays an important role. It is considered that the formed vacancy disappears when reaching the surface of the wafer, concentration is lowered nearby the outmost surface, and outward diffusion of the vacancy occurs toward the surface from the inside due to a concentration difference caused by the reduction of the concentration. Therefore, when the cooling rate is too small, it is considered that the time remaining at the time of temperature lowering is increased, the number of vacancies formed by high-temperature RTA heat treatment is decreased, and it is impossible to secure a quantity enough to form oxygen precipitate nuclei.

Therefore, after performing predetermined holding, temperature is lowered at a temperature lowering rate of 10°C/second or more. The temperature lowering rate is specified in the range of 10°C/second or more because the restraint effect of vacancy disappearance is not obtained when the temperature lowering rate is less than a lower limit value. The reason why an upper limit value is not set is that when the temperature lowering rate exceeds 10°C /second, its effect is not changed. However, setting the temperature drop rate to an excessively high value deteriorates the wafer-in-plane temperature uniformity during cooling, and slip occurs. Therefore, it is preferable to control the temperature lowering rate to 10 to 100°C/second. More preferable temperature lowering rate ranges between 15 and 50°C/second.

### (2-2) Second heat treatment step

As shown in Fig. 3(c), second heat treatment is applied to the rapid-heat-treated wafer 11. By performing the second heat treatment, oxygen precipitate nuclei 14b are formed in a wafer 11. It is preferable that second heat treatment in a second heat treatment step is performed by holding the wafer under an atmosphere of any one of hydrogen, argon, nitrogen, and oxygen gas or a mixed gas thereof at 500 to 1000°C for 1 to 96 hours. It is more preferable that the gas atmosphere of the second heat treatment is realized under argon gas or trace-quantity oxygen (nitrogen or argon gas base) gas atmosphere. The second heat treatment temperature is specified in the range of 500 to 1000°C because long-time heat treatment is necessary at a temperature lower than a lower limit value because a temperature for forming nuclei is too low but when exceeding an upper limit value, oxygen precipitate nuclei are not formed. Moreover, the second heat treatment time is specified in the range of 1 to 90 hours because time is too short to form oxygen precipitate nuclei 14b at the time shorter than a lower limit value but when exceeding an upper limit value, there is a disadvantage that productivity is lowered. It is more preferable that the second heat treatment is performed at the temperature of 500 to 800°C for 4 to 35 hours. Moreover, it is allowed to perform the second heat treatment in the range of 1 to 96 hours, preferably in the range of 4 to 35 hours by raising temperature at a rate of 0.1 to 20.0°C, preferably at a rate of 0.1 to 5.0°C/minute in a partial range or the whole range between 500 and 1,000°C.

### (2-3) Third heat treatment step

Then, as shown in Fig. 3(d), third heat treatment is applied to a second-heat-treated wafer 11. By performing the third heat treatment, it is possible to grow oxygen precipitate nuclei 14b formed in the wafer 11 so as to be oxygen precipitates 14c. It is preferable that third heat treatment in a third heat treatment step is performed by holding a second-heat-treated wafer under an atmosphere of any one of hydrogen, argon, nitrogen, and oxygen gases or a mixed gas thereof at 900 to 1250°C higher than the second heat treatment temperature for 1 to 96 hours. It is preferable that the gas atmosphere of the third heat treatment is realized under argon or trace-quantity (nitrogen or argon gas base) gas atmosphere. The third heat treatment is specified in the range of 900 to 1250°C because oxygen precipitate 14c is not sufficiently grown at a temperature lower than a lower limit value but when exceeding an upper limit value, there occurs a trouble due to slip. Moreover, the third heat treatment time is specified in the range of 1 to 96 hours because oxygen precipitates 14c in not sufficiently grown when the time is shorter than a lower limit value but when exceeding an upper limit value, there is a difficulty in productivity. Moreover, it is more preferable that the third heat treatment is performed at 1,000 to 1,200°C for 8 to 24 hr. Furthermore, it is allowed to perform the third heat treatment in the range of 1 to 96 hours, preferably in the range of 8 to 24 hours by raising temperature at a rate of 0.1 to 20°C/minute, preferably at a rate of 1 to 5° C/minute in a partial range or the whole range between 900 and 1,200°C.

### (2-4) Oxygen ion implantation step

Then, as shown in Fig. 3(e), oxygen ions are implanted into a third-heat-treated wafer 11. The implantation of oxygen ions is performed by the same means as the conventional ones. Then, oxygen ions are implanted into a region 11a at a predetermined depth from the surface of the wafer 11 so that the thickness of an SOI layer 13 on a SIMOX substrate finally obtained becomes 10 to 200 nm, preferably becomes 20 to 100 nm. When the thickness of the SOI layer 13 is less than 10 nm, it is difficult to control the thickness of the SOI layer 13. When the thickness of the SOI layer 13 exceeds 200 nm, it is difficult to implant oxygen ions from the viewpoint of acceleration voltage.
Moreover, by locally forming a mask or the like at a desired position on the surface of a silicon wafer 11 and then implanting oxygen ions into the silicon wafer 11, oxygen ions are implanted into the wafer below a portion where a mask is not formed but oxygen ions are not implanted into the wafer below a portion where a mask is formed. Therefore, by applying the subsequent first heat treatment, a buried oxide layer 12 is locally formed only below a portion where a mask is not formed. Even if there occurs heavy metal contamination due to an ion implantation step, it is possible to efficiently capture a heavy metal which is a contaminant in a bulk layer 14 by oxygen precipitates 14c formed by applying the above-described second heat treatment and third heat treatment in a bulk layer 14.

### (2-5) First heat treatment step

Then, as shown in Fig. 3(f), first heat treatment is applied to a wafer 11 into which oxygen ions are implanted under an atmosphere of inert gas or a mixed gas atmosphere of oxygen and inert gas at the temperature of 1,300 to 1390°C. As inert gas, argon gas or nitrogen gas is used. Therefore, it is preferable that the gas atmosphere of the first heat treatment is argon gas alone, a mixed gas of oxygen and argon, or a mixed gas of oxygen and nitrogen. Moreover, it is preferable that the heat treatment time of the first heat treatment ranges between 1 and 20 hr, more preferably ranges between 10 and 20 hr.
Through the first heat treatment, oxide films 11b and 11c are formed on the front surface and the rear surface of the wafer 11 and a buried oxide layer 12 is formed entirely in the wafer in a region 11a at a predetermined depth from the surface of the wafer 11. Moreover, when oxygen ions are locally implanted into a region at a predetermined depth from the surface of the wafer 11 by a mask or the like, the buried oxide layer 12 is locally formed. Moreover, an SOI layer 13 is formed between the oxide film 11b at the surface side and the buried oxide layer 12. Furthermore, a defect collection layer 14a is inevitably formed immediately below the buried oxide layer 12. Furthermore, because oxygen precipitates nearby the surface layer are melted through the first heat treatment, a DZ layer is formed. Furthermore, oxygen precipitates 14c present in a defect collection layer 14a immediately below the buried oxide layer 12 and a bulk layer 14 located below the layer 14a is further grown by temperature rise in the early stage of the first heat treatment, the size of oxygen precipitate is increased, melting of the precipitate 14c is started by holding temperature at 1,300 to 1390°C in the middle stage, and the size is decreased up to a certain size. However, the growth is restarted by temperature lowering at the last stage of the first heat treatment. Therefore, even if applying the first heat treatment, previously-formed oxygen precipitates 14c remain in the bulk 14.
Even if there occurs heavy metal contamination due to the first heat treatment step, it is possible to efficiently capture a heavy metal which is a contaminant in the bulk layer 14 by the oxygen precipitate 14c formed by applying the above-described second heat treatment step and third heat treatment step.

Though not illustrated, it is allowed to apply fourth heat treatment for holding a first-heat-treated wafer at 500 to 1,200°C for 1 to 96 hours after the first heat treatment. By applying the fourth heat treatment, it is possible to regrow oxygen precipitates 14c formed in a bulk layer 14 below a buried oxide layer 12. It is preferable that a gas atmosphere of the fourth heat treatment is realized under argon or trace-quantity oxygen (nitrogen or argon gas base) gas atmosphere. The fourth heat treatment is specified in the range of 500 to 1,200°C because oxygen precipitates 14c are not sufficiently grown at a temperature lower than a lower limit value but when exceeding an upper limit value, there occurs a trouble such as slip or the like. Moreover, the fourth heat treatment time is specified in the range of 1 to 96 hours because oxygen precipitates 14c are not sufficiently grown at the time shorter than a lower limit value but when exceeding an upper limit value, there is a difficulty in productivity. It is preferable that the fourth heat treatment is performed at 1,000 to 1,200°C for 8 to 24 hours.

### (2-6) Removal step of oxide films 11b and 11c

As shown in final Fig. 3(g), oxide films 11b and 11c on the front surface and the rear surface of a third-heat-treated wafer 11 are removed by hydrofluoric acid or the like. Thereby, there is obtained a SMOX substrate comprising; a buried oxide layer 12 formed in a region at a predetermined depth from the surface of the wafer, SOI layer 13 formed on the buried oxide layer, a defect collection layer 14a formed immediately below the buried oxide layer 12, and a bulk layer 14 below the buried oxide layer 12 and a gettering source constituted of oxygen precipitates 14c in the bulk layer 14 below the defect collection layer 14a, wherein the density of the oxygen precipitate 14c ranges between 1 × 10⁸ to 1 × 10¹² pieces/cm³ , and the size of the oxygen precipitate 14c is 50 nm or bigger.

In a bulk layer 14 below the defect collection layer 14a, this SIMOX substrate has oxygen precipitates 14c in which the density ranges between 1 × 10⁸ to 1 × 10¹² pieces/cm³ and the size is 50 nm or bigger. Therefore, it is possible to efficiently capture unexpected heavy-metal contamination in a device process by oxygen precipitates 14c. Moreover, because oxygen precipitates 14c become a gettering source stronger than the defect collection layer 14a, it is possible to get the heavy-metal contaminant conventionally captured by the defect collection layer 14a in oxygen precipitates 14c of the bulk layer 14. As a result, for example, when a substrate is forcibly contaminated by a heavy metal so that it is obtained at a heavy metal concentration of 1 × 10¹¹ to 1 × 10¹² pieces/cm², it is possible to decrease the captured heavy metal concentration of the defect collection layer 14a up to a level of 5 × 10⁹ pieces/cm² or less.

As shown in Fig. 3, in the case of this embodiment, a rapid heat treatment step, second heat treatment step, and third heat treatment step are applied before an oxygen ion implantation step. However, as shown in Figs. 4(a) to 4(g), respectively, a SIMOX substrate similar to the one shown in Fig. 3 is obtained even if the rapid heat treatment step, second heat treatment step, and third heat treatment step are applied between the oxygen ion implantation step and a first heat treatment step. Example

Then, examples of the present invention are described below in detail together with a comparative example.

### <Example 1>

First, as shown in Fig. 3(a), there was prepared a CZ silicon wafer cut into a predetermined thickness from silicon ingot having oxygen concentration of 1.2×10¹⁸ atoms/cm³ (old ASTM) and a resistivity of 20Ω·cm grown by the CZ method. Then, as shown in Fig. 3(b), rapid heat treatment was performed in which after continuously raising the temperature of the wafer under an ammonia gas atmosphere from 500 to 1, 150°C at 25°C/second, the wafer was held at 1,150°C for 15 seconds and then temperature is lowered up to 500°C at the temperature lowering rate of 25°C/second. Then, as shown in Fig. 3(c), second heat treatment for holding the rapid-heat-treated wafer 11 under a nitrogen atmosphere at 800°C for 4 hours was applied to the rapid-heat-treated wafer 11. Then, as shown in Fig. 3(d), third heat treatment was performed which holds the rapid-heat-treated wafer 11 under a 3%-oxygen gas (nitrogen gas base) atmosphere at 1000°C for 16 hours. Then, as shown in Fig. 3(e), the wafer was heated to a temperature of 550°C or lower and in this state, oxygen ions are implanted into a predetermined region (for example, region at about 0.4 µm from the surface of the substrate) of the silicon wafer under the following conditions.

Acceleration voltage: 180 keV
Beam current: 50 mA
Dose quantity: 4 × 10¹⁷ pieces/cm²
After implanting ions, SC-1 and SC-2 cleanings are applied to the surface of the wafer. Then, as shown in Fig. 3(f), the wafer 11 is put in a heat treatment furnace and held under an argon gas atmosphere having an oxygen partial pressure of 0.5% at the constant temperature of 1,350°C for 4 hours and then oxygen partial pressure of the atmosphere in the furnace is increased up to 70% and moreover, first heat treatment for holding the wafer for 4 hours is performed. Oxide films 11b and 11c on the front surface and the rear surface of the first-heat-treated wafer are removed by HF solution to obtain the SIMOX substrate shown in Fig. 3(g). The SIMOX substrate is used as Example 1.

### <Example 2>

First, as shown in Fig. 4(a), there was prepared a CZ silicon wafer cut into a predetermined thickness from silicon ingot having an oxygen concentration of 1.2×10¹⁸ atoms/cm³ (old ASTM) and resistivity of 20Ω·cm grown by the CZ method. Then, as shown in Fig. 4(b), the wafer is heated to a temperature of 550°C or lower and in this state, oxygen ions were implanted into a predetermined region of the silicon wafer (for example, region at about 0.4 *µ*m from the surface of a substrate) under the same conditions as in the above example 1. After implanting oxygen ions, SC-1 and SC-2 cleanings were applied to the surface of the wafer. Then, as shown in Fig. 4(c), the temperature of the wafer was continuously raised up to 500 to 1150°C at 25°C /second under an ammonia gas atmosphere and then the wafer was held at 1,150°C for 15 seconds and then rapid heat treatment for lowering the temperature of the wafer up to 500° C at temperature lowering rate of 25°C/second was applied to the wafer. Then, as shown in Fig. 4(d), second heat treatment was applied to the rapid heat-treated wafer 11 under argon atmosphere at 800°C for 4 hours. Then, as shown in Fig. 4(e), third heat treatment was performed which held the second-heat-treated wafer under 0.5%-oxygen gas (argon gas base) atmosphere at 1000°C for 16 hours. Then, as shown in Fig. 4(f), the wafer 11 was put in a heat treatment furnace and held under an argon gas atmosphere of oxygen partial pressure of 0.5% at the constant temperature of 1,350°C for 4 hours and then the oxygen partial pressure of the atmosphere in the furnace was continuously increased up to 70% and moreover first heat treatment for holding the wafer for 4 hours was performed. Oxide films 11b and 11c on the front surface and the rear surface of the first-heat-treated wafer are removed by HF solution to obtain the SIMOX substrate shown in Fig. 4(g). The SIMOX substrate is referred to as Example 2.

### <Example 3>

First, as shown in Fig. 1(a), there was a CZ silicon wafer cut into a predetermined thickness from silicon ingot having an oxygen concentration of 1.3×10¹⁸ atoms/cm³ (old ASTM), carbon concentration of 5 × 10¹⁶ atoms/cm³ (old ASTM) and a resistivity of 20Ω·cm grown by the CZ method. Then, as shown in Fig. 1(b), second heat treatment was performed which held the wafer 11 under a 3%-oxygen gas atmosphere (argon gas base) at 800°C for 4 hours. Then, as shown in Fig. 1(c), third heat treatment was performed which held the second-heat-treated wafer under a 3%-oxygen gas (argon gas base) atmosphere at 1000°C for 8 hours. Then, as shown in Fig. 1(d), the wafer was heated to a temperature of 550°C or lower and in this state, oxygen ions were implanted into a predetermined region of the silicon wafer (for example, region at about 0.4*µ*m from substrate surface) under the same conditions as in the above Example 1.
After implanting ions, SC-1 and SC-2 cleanings were applied to the surface of the wafer. Then, as shown in Fig. 1(e), the wafer 11 was put in a heat treatment furnace and held under an argon gas atmosphere having an oxygen partial pressure of 0.5% for 4 hours at the constant temperature of 1350°C, then the oxygen partial pressure of the atmosphere in the furnace was increased up to 70% to perform first heat treatment for further holding the wafer for 4 hours. Oxide films 11b and 11c on the front surface and the rear surface of the first-heat-treated wafer were removed by HF solution to obtain the SIMOX substrate shown in Fig. 1(f). The SIMOX substrate is referred to as Example 3.

### < Example 4>

First, as shown in Fig. 1(a), there was a CZ silicon wafer cut into a predetermined thickness from silicon ingot having an oxygen concentration of 1.35 ×10¹⁸ atoms/cm³ (old ASTM) and resistivity of 20 Ω · cm grown by the CZ method. Then, as shown in Fig. 1(b), the second heat treatment was performed in which the temperature of the wafer was continuously raised at 0.5°C/minute under an argon atmosphere from 500 to 850°C and then the wafer was held at 850°C for 1 hour. Then, as shown in Fig. 1(c), the temperature of the second-heat-treated wafer 11 was raised from 850°C to 1100°C under an argon atmosphere at the temperature raising rate of 3.0°C/minute and the third heat treatment for holding the wafer at 1100°C for 16 hours. Then, as shown in Fig. 1(d), the wafer was heated to the temperature of 550°C or lower and in this state, oxygen ions were implanted into a predetermined region (for example, region at about 0.4*µ*m from the surface of the wafer) under the same conditions as in the above example 1.
After implanting ions, SC-1 and SC-2 cleanings were applied to the surface of the wafer. Then, as shown in Fig. 1(e), first heat treatment was performed in which the wafer 11 was put in a heat treatment furnace to hold the wafer under an argon gas atmosphere having an oxygen partial pressure of 0.5% at the constant temperature of 1,350°C for 4 hours, the oxygen partial pressure in the atmosphere of the furnace was continuously raised up to 70%, and moreover, the wafer was held for 4 hours. Oxide films 11b and 11c on the front surface and the rear surface of the first-heat-treated wafer were removed by HF solution to obtain the SMIOX substrate shown in Fig. 1(f). The SIMOX substrate is referred to as Example 4.

### <Examples 5 to 8>

Fourth heat treatment was performed in which the first-heat-treated wafers of Examples 1 to 4 were held under 0.5% oxygen gas (argon gas base) atmosphere at 1000°C for 16 hours. Oxide films on the front surface and the rear surface of the fourth-heat-treated wafer were removed by HF solution to obtain a SMOX substrate. The SIMOX substrate is referred to as Examples 5 to 8.

### <Comparative example 1>

First, there was a CZ silicon wafer cut into a predetermined thickness from silicon ingot having an oxygen concentration of 1.3×10¹⁸ atoms/cm³ (old ASTM) and resistivity of 20Ω·cm grown by the CZ method. Then, the wafer was heated to the temperature of 550°C or lower and in this state, oxygen ions were implanted into a predetermined region (for example, region at about 0.4 µm from the surface of a substrate) under the same conditions as in the above Example 1.
After implanting ions, SC-1 and SC-2 cleanings were applied to the surface of the wafer. Then, the wafer was put in a heat treatment furnace to hold the wafer under an argon gas atmosphere having an oxygen partial pressure of 0.5% at the constant temperature of 1,350°C for 4 hours. Then, first heat treatment was performed which increased the oxygen partial pressure of the atmosphere in the furnace up to 70% and moreover held the wafer for 4 hours. Oxide films on the front surface and the rear surface of the first-heat-treated wafer were removed by HF solution to obtain a SIMOX substrate. This SIMOX substrate is referred to as Comparative example 1.

### <Comparative example 2>

Fourth heat treatment was performed which held the wafer completing the first heat treatment of the comparative example 1 under a 3% oxygen gas (argon gas base) atmosphere at 1000°C for 16 hours. Oxide films on the front surface and the rear surface of the fourth-heat-treated wafer were removed by HF solution to obtain a SIMOX substrate. The SIMOX substrate is referred to as Comparative example 2.

### <Comparative test 1>

Surface oxide films 11b and 11c of each of SIMOX substrates 10 of Examples 1 to 8 and each of comparative examples 1 and 2 were removed and then, an SOI layer 13, a buried oxide layer 12, and a defect collection layer 14a immediately below the buried oxide layer of each SIMOX substrate were melted by hydrofluoric-acid solution and nitric-acid aqueous solution, respectively, and collected. ICP-MS measurement was applied to these collected melted solutions to measure the nickel concentration included in the melted solutions. Moreover, bulk layers 14 of examples 1 to 8 and comparative examples 1 and 2 were divided into bulk layers excluding a thickness of 1µm from the rear surface and regions at 1µm from the rear surface to fully melt them and thereby measure the nickel concentration in each melted solution.
Though nickel was detected from bulk layers excluding 1 µm from the SMIOX substrates of examples 1 to 8, nickel was not detected from other regions. In the SIMOX substrates of comparative examples 1 and 2, nickel was detected from the defect collection layer 14a immediately below a buried oxide layer. That is, it was found that nickel contamination was not detected from a SIMOX substrate obtained from the method of the present invention immediately below a buried oxide layer which may influence a device region.

### <Comparative example 2>

SIMOX substrates of Example 5 and comparative example 2 were respectively cleaved into two parts. Selective etching was applied to the cleaved substrates by a wright etching solution. The cleaved substrates in Example 5 and comparative example 2 were respectively observed by an optical microscope. In Example 5, it was observed that oxygen precipitates were grown in the substrate at a high density at the depth of 2µm from the surface of the cleaved face. However, in Comparative example 2, oxygen precipitates were hardly grown. That is, even if heat treatment step requiring 1,300°C or higher was applied to form an oxide film, it was clarified that the oxygen precipitates did not disappear by sufficiently growing oxygen precipitates before the heat treatment and it was found that oxygen precipitates had a gettering effect in the step of manufacturing a SIMOX.

### INDUSTRIAL APPLICABILITY

A SIMOX substrate manufacturing method of the present invention makes it possible to efficiently capture heavy metal contamination due to ion implantation or high-temperature heat treatment into a bulk layer.

## Claims

1. A method for manufacturing a SIMOX substrate comprising:
an oxygen ion implantation step of implanting oxygen ions into a silicon wafer; and
a first heat treatment step of forming a buried oxide layer in a region at a predetermined depth from the surface of the wafer and forming an SOI layer on the buried oxide layer by applying first heat treatment to the wafer under a mixed gas atmosphere of oxygen and inert gases at 1,300 to 1, 390°C; wherein
the silicon wafer before oxygen ions are implanted has an oxygen concentration of 9×10¹⁷ to 1.8×10¹⁸ atoms/cm³ (old ASTM) and the buried oxide layer is formed entirely or locally in the wafer, and
the following steps further comprise: a second heat treatment step of forming oxygen precipitate nuclei in the wafer before the oxygen ion implantation step or between the oxygen ion implantation step and the first heat treatment step, and third heat treatment step of growing oxygen precipitate nuclei formed in the wafer continued from the second heat treatment step so as to be oxygen precipitates.

2. The method according to claim 1, wherein
second heat treatment in a second heat treatment step is performed by holding a wafer under an atmosphere of any one of hydrogen, argon, nitrogen, and oxygen gases or a mixed gas atmosphere thereof at a temperature of 500 to 900°C for 1 to 96 hours and third heat treatment in a third heat treatment step is performed by holding the second-heat-treated wafer under any one of atmosphere of hydrogen, argon, nitrogen, and oxygen gases or a mixed gas atmosphere thereof at a temperature of 900 to 1250°C higher than the second heat treatment temperature for 1 to 96 hours.

3. The method according to claim 1, further comprising:
a fourth heat treatment step of regrowing oxygen precipitates formed in a bulk layer below a buried oxide layer by performing fourth heat treatment for holding a first-heat-treated wafer at 500 to 1200°C for 1 to 96 hours.

4. The method according to claim 1 or 2, wherein
second heat treatment in a second heat treatment step is performed in the range of 1 to 96 hours by raising temperature at a rate of 0.1 to 20.0°C/minute in a partial range or the whole range between 500 and 900°C and third heat treatment in a third heat treatment step is performed in the range of 1 to 96 hours by raising temperature at a rate of 0.1 to 20°C/minute in a partial range or the whole range between 900 and 1250°C.

5. A method for manufacturing a SIMOX substrate comprising:
an oxygen ion implantation step of implanting oxygen ions into a silicon wafer; and
a first heat treatment step of forming a buried oxide layer in a region at a predetermined depth from the surface of the wafer and forming an SOI layer on the buried oxide layer by applying first heat treatment to the wafer under a mixed gas atmosphere of oxygen and inert gases at 1,300 to 1390°C; wherein
the silicon wafer before oxygen ions are implanted has an oxygen concentration of 9×10¹⁷ to 1.8×10¹⁸ atoms/cm³ (old ASTM) and the buried oxide layer is formed entirely or locally in the wafer, and
the following steps further comprise: a rapid heat treatment step of forming a vacancy in the wafer before the oxygen ion implantation step or between the oxygen ion implantation step and the first heat treatment step, a second heat treatment step of forming oxygen precipitate nuclei in the wafer continued from the rapid heat treatment step, and a third heat treatment step of growing oxygen precipitate nuclei formed in the wafer continued from the second heat treatment step so as to be oxygen precipitates.

6. The method according to claim 5, wherein rapid heat treatment in a rapid heat treatment step is performed by holding a wafer under a mixed gas atmosphere of non-oxidation gas or ammonia gas at 1050 to 1350°C for 1 to 900 seconds and then lowering temperature at a temperature lowering rate of 10°C/second or more, second heat treatment in a second heat treatment step is performed by holding the rapid heat-treated wafer under an atmosphere of any one of hydrogen, argon, nitrogen, and oxygen gases or a mixed gas atmosphere thereof at 500 to 1000°C for 1 to 96 hours, and third heat treatment in a third heat treatment step is performed by holding the second-heat-treated wafer under an atmosphere of any one of hydrogen, argon, nitrogen, and oxygen gases or a mixed gas atmosphere thereof at 900 to 1250°C higher than the second heat treatment temperature for 1 to 96 hours.

7. The method according to claim 5, further comprising:
a step of regrowing oxygen precipitates formed in a bulk layer below a buried oxide layer by applying fourth heat treatment to the first-heat-treated wafer at 500 to 1,200°C for 1 to 96 hours.

8. The method according to claim 5 or 6, wherein
second heat treatment in a second heat treatment step is performed in the range of 1 to 96 hours by raising temperature at a rate of 0.1 to 20.0°C/min in a partial range or the whole range between 500 and 1000°C and third heat treatment in a third heat treatment step is performed in the range of 1 to 96 hours by raising temperature at a rate of 0.1 to 20°C/minute in a partial range or whole range between 1,000 and 1250°C.

9. A SIMOX substrate manufactured in the method of any one of claims 1 to 8, comprising a buried oxide layer formed in a region at a predetermined depth from the surface of a wafer, an SOI layer formed on the buried oxide layer, a defect collection layer formed immediately below the buried oxide layer, and a bulk layer below the buried oxide layer, wherein
the substrate has a gettering source constituted of oxygen precipitates in the bulk layer below the defect collection layer, and the density of the oxygen precipitate ranges between 1 × 10⁸ and 1 × 10¹² pieces/cm³, and the size of the oxygen precipitate is 50 nm or bigger.
